# EUROPEAN PATENT APPLICATION

(11) **EP 4 535 738 A1**
(43) Date of publication of application: **09.04.2025**
(21) Application number: 22944158.9
(22) Date of filing: 31.05.2022
(51) Int. Cl.: H04L 27/00, G06F 30/27, G06N 3/02

(54) **BEAM MANAGEMENT METHOD AND APPARATUS, USER EQUIPMENT AND NETWORK DEVICE**

(71) Applicant: GUANGDONG OPPO MOBILE TELECOMMUNICATIONS CORP., LTD., Dongguan, Guangdong 523860 (CN)
(72) Inventor: LIU, Wendong, Dongguan, Guangdong 523860 (CN); CAO, Jianfei, Dongguan, Guangdong 523860 (CN)
(74) Representative: RGTH
(86) International application number: PCT/CN2022/096170
(87) International publication number: WO 2023/230818

(57) **Abstract**

The embodiments of the present application provide a beam management method and apparatus, a user equipment, and a network device. The method includes: measuring, by a UE, link qualities of multiple beams or multiple beam pairs; and determining, by the UE, at least one receiving beam index and/or uplink feedback information by utilizing a first sub-model based on the link qualities of the multiple beams or the multiple beam pairs, where the uplink feedback information is used to determine at least one transmitting beam index and/or at least one link quality corresponding to at least one transmitting beam index; receiving, by a network device, uplink feedback information sent from the UE; and determining, by the network device, at least one transmitting beam index and/or at least one link quality corresponding to the at least one transmitting beam index by utilizing a second sub-model based on the uplink feedback information.

## Description

### TECHNICAL FIELD

Embodiments of the present application relate to the field of mobile communication technology, and in particular to a beam management method and apparatus, a user equipment, and a network device.

### BACKGROUND

The analog beamforming technology can reduce the implementation complexity of a device while enhancing the network coverage. The analog beamforming not only may be used for a network device, but also may be used for a user equipment (UE).

In order to obtain a good communication quality, an optimal transmitting beam and/or an optimal receiving beam needs to be determined. In a current downlink beam management procedure, in order to determine the optimal transmitting beam and/or the optimal receiving beam, the UE needs to traverse all transmitting beams and/or traverse all receiving beams to perform corresponding link quality measurement, which will result in a large amount of overhead and delay.

### SUMMARY

Embodiments of the present application provide a beam management method and apparatus, a user equipment, a network device, a chip, a computer-readable storage medium, a computer program product, and a computer program.

The beam management method provided in the embodiments of the present application includes:
measuring, by a UE, link qualities of multiple beams or multiple beam pairs; and
determining, by the UE, at least one receiving beam index and/or uplink feedback information by utilizing a first sub-model based on the link qualities of the multiple beams or the multiple beam pairs, where the uplink feedback information is used to determine at least one transmitting beam index and/or at least one link quality corresponding to the at least one transmitting beam index.

The beam management method provided in the embodiments of the present application includes:
receiving, by a network device, uplink feedback information sent from a UE; and
determining, by the network device, at least one transmitting beam index and/or at least one link quality corresponding to the at least one transmitting beam index by utilizing a second sub-model based on the uplink feedback information.

The beam management apparatus provided in the embodiments of the present application is applied to a UE, and the apparatus includes:
a measurement unit, configured to measure link qualities of multiple beams or multiple beam pairs; and
a processing unit, configured to determine at least one receiving beam index and/or uplink feedback information by utilizing a first sub-model based on the link qualities of the multiple beams or the multiple beam pairs; where the uplink feedback information is used to determine at least one transmitting beam index and/or at least one link quality corresponding to the at least one transmitting beam index.

The beam management apparatus provided in the embodiments of the present application is applied to a network device, and the apparatus includes:
a receiving unit, configured to receive uplink feedback information sent from a UE; and
a processing unit, configured to determine at least one transmitting beam index and/or at least one link quality corresponding to the at least one transmitting beam index by utilizing a second sub-model based on the uplink feedback information.

The user equipment provided in the embodiments of the present application includes a processor and a memory. The memory is used to store a computer program, and the processor is used to invoke and execute the computer program stored in the memory to perform the beam management method described above.

The network device provided in the embodiments of the present application includes a processor and a memory. The memory is used to store a computer program, and the processor is used to invoke and execute the computer program stored in the memory to perform the beam management method described above.

The chip provided in the embodiments of the present application is used to implement the beam management method described above.

Specifically, the chip includes: a processor, used to invoke and execute a computer program from a memory, causing a device equipped with the chip to perform the beam management method described above.

The computer-readable storage medium provided in the embodiments of the present application is used to store a computer program, where the computer program causes a computer to perform the beam management method described above.

The computer program product provided in the embodiments of the present application includes a computer program instruction, where the computer program instruction causes a computer to perform the beam management method described above.

The computer program provided in the embodiments of the present application, when executed on a computer, causes a computer to perform the beam management method described above.

In the technical solutions of the embodiments of the present application, the first sub-model is deployed on the UE side, so that the UE can predict (i.e., infer) at least one optimal receiving beam index and/or uplink feedback information based on link qualities of measured beams or beam pairs through the first sub-model in a case where the UE measures the link qualities of a small number of beams or beam pairs. On the other hand, the second sub-model is deployed on the network device side, so that the network device can predict at least one optimal transmitting beam index and/or at least one corresponding link quality based on the uplink feedback information of the UE through the second sub-model. By adopting the technical solutions of the embodiments of the present application, an optimal transmitting beam and/or an optimal receiving beam can be quickly determined, and resource overhead and delay in a beam scanning process can be significantly reduced.

### BRIEF DESCRIPTION OF THE DRAWINGS

The accompanying drawings described here are used to provide further understanding of the present application and constitute a part of the present application. The exemplary embodiments of the present application and description thereof are used to explain the present application and do not constitute improper limitations on the present application. The accompanying drawings include the following.
FIG. 1 is a schematic diagram of an application scenario of the embodiments of the present application.
FIG. 2 is a schematic diagram of a neuron structure.
FIG. 3 is a schematic diagram of a deep neural network.
FIG. 4 is a schematic diagram of a convolutional neural network.
FIG. 5 is a schematic diagram of an LSTM unit structure.
FIG. 6 is a schematic diagram of a downlink beam scanning process.
FIG. 7 is a schematic flowchart of a beam management method provided in the embodiments of the present application.
FIG. 8 is a schematic diagram of a split deployment manner for models on a UE side and an NW side provided in the embodiments of the present application.
FIG. 9-1 is a first schematic structural diagram of a sub-model on a UE side provided in the embodiments of the present application.
FIG. 9-2 is a second schematic structural diagram of a sub-model on a UE side provided in the embodiments of the present application.
FIG. 9-3 is a third schematic structural diagram of a sub-model on a UE side provided in the embodiments of the present application.
FIG. 9-4 is a fourth schematic structural diagram of a sub-model on a UE side provided in the embodiments of the present application.
FIG. 10 is a schematic diagram of a training process for a model provided in the embodiments of the present application.
FIG. 11 is a schematic diagram of a beam indication process provided in the embodiments of the present application.
FIG. 12 is a first schematic diagram of a structure of a beam management apparatus provided in the embodiments of the present application.
FIG. 13 is a second schematic diagram of a structure of a beam management apparatus provided in the embodiments of the present application.
FIG. 14 is a schematic structural diagram of a communication device provided in the embodiments of the present application.
FIG. 15 is a schematic structural diagram of a chip in the embodiments of the present application.
FIG. 16 is a schematic block diagram of a communication system provided in the embodiments of the present application.

### DETAILED DESCRIPTION

The technical solutions in the embodiments of the present application will be described below in connection with the accompanying drawings in the embodiments of the present application. Obviously, the described embodiments are only a part of the embodiments of the present application, rather than all of the embodiments. Based on the embodiments in the present application, all other embodiments obtained by ordinary skilled in the art without any creative effort shall fall within the scope of protection of the present application.

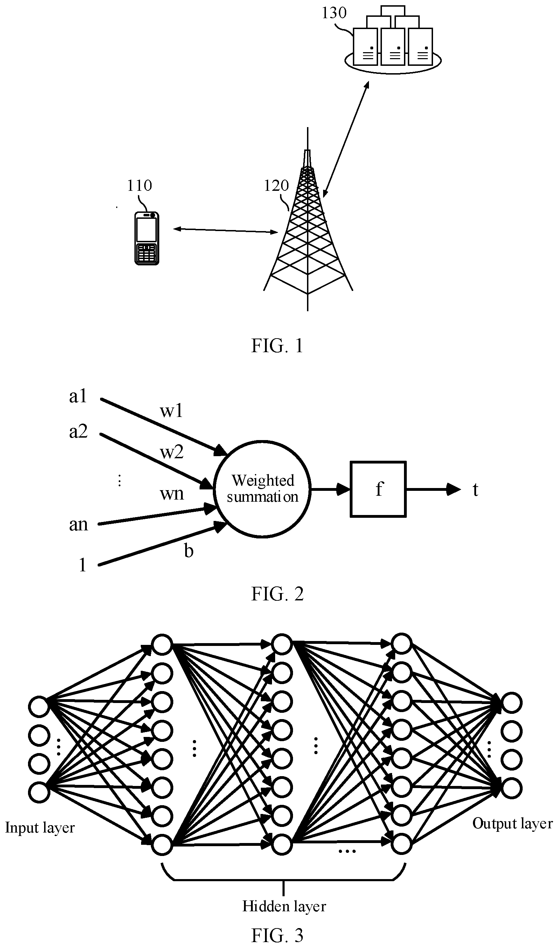

FIG. 1 is a schematic diagram of an application scenario of the embodiments of the present application. As shown in FIG. 1, a communication system may include a user equipment 110 and a network device 120. The network device 120 may communicate with the user equipment 110 via an air interface.

It should be understood that although the embodiments of the present application are illustrated by taking the communication system shown in FIG. 1 as an example, but the embodiments of the present application are not limited thereto. That is, the technical solutions of the embodiments of the present application may be applied to various communication systems, such as a 5G communication system (also referred to as a new radio (NR) communication system), or a future communication system, etc.

In the communication system shown in FIG. 1, the network device 120 may be an access network device that communicates with the user equipment 110. The access network device may provide a communication coverage for a specific geographical area and may communicate with the user equipment 110 located within the coverage area. As an example, the access network device may be a base station (gNB) in an NR system.

In the communication system shown in FIG. 1, the user equipment 110 may be any user equipment, such as a mobile phone, a handheld device with wireless communication functions, a vehicle-mounted device, a wearable device, etc.

The wireless communication system shown in FIG. 1 may further include a core network device 130 that communicates with the access network device. During a network evolution process, names of the core network device 130 may be different.

It should be noted that the terms "system" and "network" herein are often used interchangeably herein. The term "and/or" herein is only an association relationship for describing associated objects, meaning that there may be three kinds of relationships, for example, A and/or B may mean three cases where: A exists alone, both A and B exist, and B exists alone. In addition, a character "/" herein generally means that associated objects before and after "/" are in an "or" relationship. It also should be understood that, the "indicate/indication/indicating/indicated" mentioned in the embodiments of the present application may be a direct indication, may also be an indirect indication, or may also represent having an association relationship. For example, A indicating B, may mean that A directly indicates B, for example, B may be obtained via A; may also mean that A indirectly indicates B, for example, A indicates C, and B may be obtained via C; may also mean that there is an association relationship between A and B. It also should be understood that, the "correspond/corresponding" mentioned in the embodiments of the present application may mean that there is a direct correspondence or indirect correspondence between two objects, may also mean that there is an association relationship between the two objects, or may also mean relationships of indicating and being indicated, of configuring and being configured, etc. It should also be understood that the "predefined" or "predefined rule" mentioned in the embodiments of the present application may be implemented by pre-saving corresponding codes, tables or other manners that may be used for indicating related information, in the device (for example, including the user equipment and the network device), and the present application does not limit its specific implementation. For example, the predefined may refer to what is defined in a protocol. It should further be understood that, in the embodiments of the present application, the "protocol" may refer to a standard protocol in the field of communication, which may include, for example, an LTE protocol, an NR protocol, and related protocols applied in the future communication system, and the present application is not limited thereto.

To facilitate understanding of the technical solutions of the embodiments of the present application, the relevant technologies of the embodiments of the present application are illustrated below, and the following relevant technologies may be, as optional solutions, arbitrarily combined with the technical solutions of the embodiments of the present application, which all belong to the protection scope of the embodiments of the present application.

### Neural Network and Machine Learning

A neural network is an operating model composed of multiple interconnected neurons (referred to as nodes abbreviatedly), where the connection between nodes represents a weight value, which is referred to as a weight. One node may be connected to multiple up-one-level nodes, and outputs of the multiple up-one-level nodes are used as an input to the node. The node performs weighted summation on inputs by utilizing weights, and performs processing on an obtained result through a specific activation function. As an example, a neuron structure is shown in FIG. 2. A neuron utilizes n weights (which are denoted as w1, w2..., wn) to perform the weighted summation on n inputs (which are denoted as a1, a2,..., an), performs processing on an obtained result through an activation function (which is denoted as f), and finally outputs t. Optionally, after the neuron performs the weighted summation, a bias b may further be added to the obtained result.

There are many types of neural networks, and a deep neural network (DNN) is a common neural network. In addition to the deep neural network, there are further types of neural networks, such as a convolutional neural network (CNN), a recurrent neural network (RNN), etc.

FIG. 3 is a typical deep neural network. As shown in FIG. 3, basic structures of a deep neural network include: an input layer, a hidden layer, and an output layer. An input of the input layer is an input of the deep neural network, and an output of the output layer is an output of the deep neural network. For the deep neural network, by designing different connection manners for nodes, different weights, and different activation functions, the deep neural network may be enabled to produce different outputs, thereby fitting a mapping relationship between an input and an output. The deep neural network shown in FIG. 3 is a fully connected model, where each node is connected to all next-one-level nodes of the node.

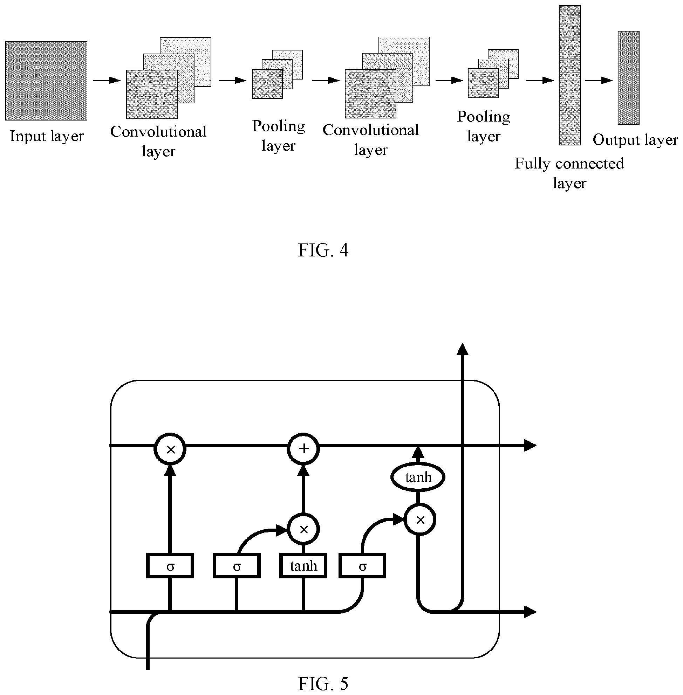

FIG. 4 is a typical convolutional neural network. As shown in FIG. 4, basic structures of the convolutional neural network includes: an input layer, multiple convolutional layers, multiple pooling layers, a fully connected layer and an output layer. An input of the input layer is an input of the convolutional neural network, and an output of the output layer is an output of the convolutional neural network. For the convolutional neural network, each neuron of a convolution kernel in a convolution layer is locally connected to an input of the neuron, and a maximum value or a feature of an average value of a part of a certain layer is extracted by introducing an pooling layer, thus effectively reducing parameters of the network and mines local features, so that the convolutional neural network may converge quickly and excellent performance is obtained.

A recurrent neural network is a type of neural network that models sequential data and has achieved remarkable results in the field of natural language processing, e.g., in the application such as machine translation and speech recognition, etc. Specifically, the recurrent neural network memorizes information from a past moment and uses the information in calculation for a current output, that is, nodes between hidden layers are no longer disconnected but connected, and an input of a hidden layer includes not only an input from an up-one-level layer, but also an output of the hidden layer at a last moment. A recurrent neural network generally includes a long-short term memory (LSTM) artificial neural network unit structure. FIG. 5 is a typical LSTM unit structure. As shown in FIG. 5, the LSTM unit structure includes: tanh nodes and σ nodes. Differ from the convolutional neural network that only considers a most recent state, a cell state of the LSTM will decide which states should be retained and which states should be forgotten, thereby solving the defects of the traditional convolutional neural network in long-term memory.

It should be noted that the neural network in the technical solutions of the embodiments of the present application may be a deep neural network, but is not limited to thereto. The deep neural network may also be replaced by a convolutional neural network or a recurrent neural network as the neural network in the technical solutions of the embodiments of the present application.

### Beam management

A beam management mechanism is classified into an uplink beam management mechanism and a downlink beam management mechanism. The downlink beam management mechanism includes processes, such as a downlink beam scanning, reporting an optimal beam by a UE, and indicating a downlink beam by a network device, etc. It should be noted that, for a network device, a downlink beam refers to a transmitting beam of the network device; and for a UE, a downlink beam refers to a receiving beam of the UE.

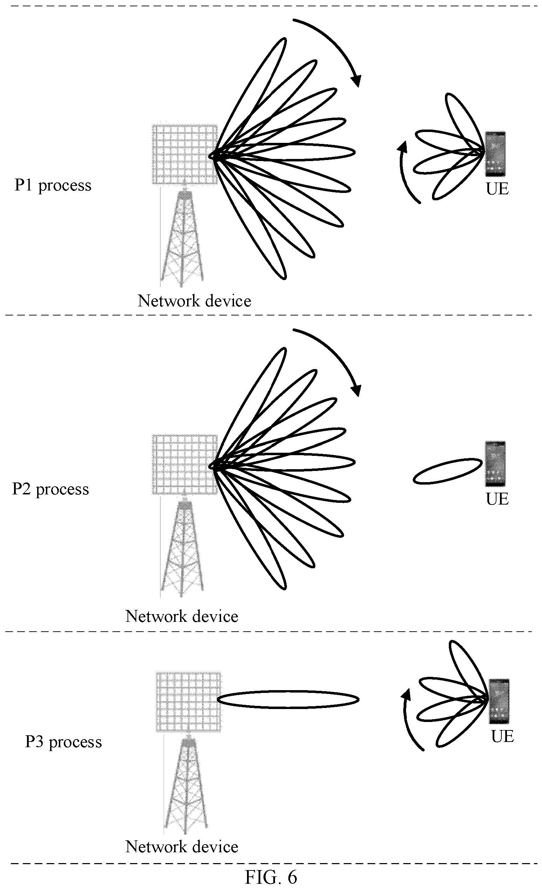

As shown in FIG. 6, a process of the downlink beam scanning includes three processes, namely a P1 process, a P2 process and a P3 process, respectively. For the P1 process, a network device traverses all transmitting beams and a UE traverses all receiving beams, so that all combinations of beam pairs may be traversed, and the UE measures a corresponding link quality for each beam pair. For the P2 process, a receiving beam is specific for the UE, and the network device traverses all transmitting beams, so that all transmitting beams may be traversed for the specific receiving beam, and the UE measures a corresponding link quality for each transmitting beam. For the P3 process, a transmitting beam is specific for the network device, and the UE traverses all the receiving beams, so that all the receiving beams may be traversed for the specific transmitting beam, and the UE measures a corresponding link quality for each receiving beam.

After the UE performs link quality measurement, the UE selects K beams or beam pairs with a highest link quality (i.e., K optimal beams or beam pairs) by comparing link qualities of all measured beams or beam pairs, and then reports the K beams or beam pairs to the network device through uplink control information, where K is a positive integer.

After the network device acquires the K optimal beams or beam pairs, the network device selects a transmitting beam for usage in downlink transmission from the K optimal beams or beam pairs, and completes an indication for the transmitting beam through a transmission configuration indication (TCI) state carried in a media access control-control element (MAC CE) or downlink control information (DCI). The UE uses a receiving beam corresponding to the transmitting beam to receive the downlink transmission.

The beam scanning process described above needs to traverse all transmitting beams and/or receiving beams, and thus causing a large amount of overhead and delay. For example, assuming that the network device has 64 transmitting beams and the UE has 4 receiving beams, then for the P1 process, the UE needs to measure 256 (i.e., 64×4) beam pairs, thereby requiring 256 downlink resource overheads. From the perspective of time, the measurement for each beam pair takes a certain amount of time to complete, and a very large amount of time will be required to measure 256 beam pairs. It can be seen that the current beam scanning process will cause a large amount of overhead and delay.

In the technical solutions of the embodiments of the present application, artificial intelligence/machine learning (AI/ML) technology is used, a neural network is trained by constructing a data set and a deployment is performed on a UE side and/or a network device side, so that the UE is enabled to predict (i.e., infer) at least one optimal receiving beam index and/or uplink feedback information through the neural network in a case where measurement results of a portion of beams or beam pairs are used as inputs to the neural network. The network device predicts, through a neural network, at least one optimal transmitting beam index and/or at least one corresponding link quality according to the uplink feedback information reported from the UE. In this way, the network device and the UE are enabled to quickly match an optimal transmitting beam and/or an optimal receiving beam, and the resource overhead and delay in the beam scanning process can be significantly reduced.

To facilitate understanding of the technical solutions of the embodiments of the present application, the technical solutions of the present application are described in detail below through specific embodiments. The relevant technologies described above, as optional solutions, may be arbitrarily combined with the technical solutions of the embodiments of the present application, and all belong to the protection scope of the embodiments of the present application. The embodiments of the present application include at least a part of the following contents.

It should be noted that the beam described in the embodiments of the present application refers to a transmitting beam or a receiving beam, and the beam pair refers to a pair of transmitting beam and receiving beam.

It should be noted that the "model" described in the embodiments of the present application may also be referred to as a "neural network", which may be, but is not limited to: a deep neural network, a convolutional neural network, and a recurrent neural network.

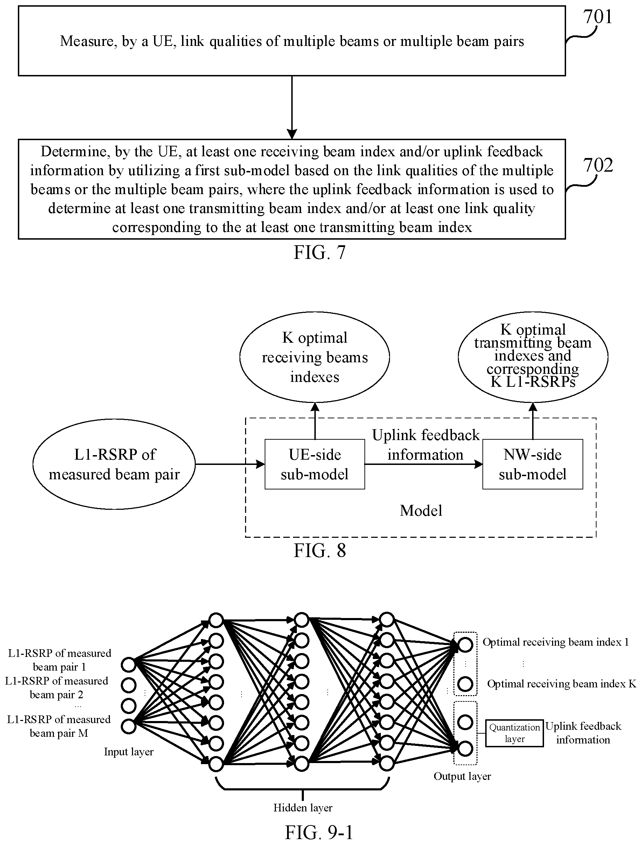

FIG. 7 is a schematic flowchart of a beam management method provided in the embodiments of the present application. As shown in FIG. 7, the beam management method includes the following steps.

In step 701, a UE measures link qualities of multiple beams or multiple beam pairs.

In step 702, the UE determines at least one receiving beam index and/or uplink feedback information by utilizing a first sub-model based on the link qualities of the multiple beams or the multiple beam pairs, where the uplink feedback information is used to determine at least one transmitting beam index and/or at least one link quality corresponding to the at least one transmitting beam index.

In some optional implementations, multiple beams measured by the UE are a subset of all beams. Here, the all beams refer to all transmitting beams or all receiving beams, that is, all transmitting beams of a network device or all receiving beams of a UE.

In some optional implementations, beam pairs measured by the UE is a subset of all beam pairs. Here, all beam pairs refer to all pairs of transmitting beam and receiving beam, that is, the pairs of transmitting beam and receiving beam formed by all possible combinations of all receiving beams of the UE and all transmitting beams of the network device.

In the embodiments of the present application, a link quality of a beam refers to a link quality corresponding to a transmitting beam. A link quality of a beam pair refers to a link quality corresponding to a pair of a transmitting beam and a receiving beam.

In the embodiments of the present application, measurement for a beam or a beam pair refers to measurement for a reference signal associated with the beam or the beam pair.

In some optional implementations, the reference signal includes at least one of: a synchronization signal and PBCH block (SSB) or a channel state information-reference signal (CSI-RS).

In some optional implementations, the link quality includes at least one of: a layer 1-reference signal receiving power (L1-RSRP), a layer 1-signal to interference plus noise ratio (L1-SINR), or a layer 1-reference signal receiving quality (L1-RSRQ).

In the embodiments of the present application, after the UE measures the link qualities of the multiple beams or the multiple beam pairs, the UE determines the at least one receiving beam index and/or the uplink feedback information by utilizing the first sub-model based on the link qualities of the multiple beams or the multiple beam pairs. Here, the multiple beams are multiple receiving beams or multiple transmitting beams, and the multiple beam pairs are multiple pairs of transmitting beams and receiving beams.

As an implementation, after the UE measures the link qualities of multiple beams (referring to multiple transmitting beams here), the UE determines the uplink feedback information by utilizing the first sub-model based on the link qualities of the multiple beams.

As another implementation, after the UE measures the link qualities of multiple beams (referring to multiple receiving beams here), the UE determines the at least one receiving beam index by utilizing the first sub-model based on the link qualities of the multiple beams.

As another implementation, after the UE measures the link qualities of multiple beam pairs (referring to multiple pairs of transmitting beams and receiving beams here), the UE determines the at least one receiving beam index and the uplink feedback information by utilizing the first sub-model based on the link qualities of the multiple beam pairs.

In some optional implementations, in a case where the UE determines the uplink feedback information, the UE sends the uplink feedback information to the network device, and accordingly, the network device receives the uplink feedback information sent from the UE. The network device determines at least one transmitting beam index and/or at least one link quality corresponding to the at least one transmitting beam index by utilizing a second sub-model based on the uplink feedback information.

Here, the uplink feedback information is used for the network device to determine the at least one transmitting beam index and/or the at least one link quality corresponding to the at least one transmitting beam index by utilizing the second sub-model.

In the solution described above, the at least one receiving beam index is indexes of K receiving beams with a best link quality in the multiple beams or the multiple beam pairs, where K is a positive integer. Here, the at least one receiving beam index may be denoted as K optimal receiving beam indexes.

In the solution described above, the at least one transmitting beam index is indexes of K transmitting beams with a best link quality in the multiple beams or the multiple beam pairs, where K is a positive integer. Here, the at least one transmitting beam index may be denoted as K optimal transmitting beam indexes.

Here, a value of K may be configured by the network, or may be predefined, or may be determined based on the implementation of the UE itself.

In the embodiments of the present application, since the link quality is a link quality of a beam or a link quality of a beam pair, there is a correspondence relationship between a transmitting beam and the link quality, or there is a correspondence relationship between a receiving beam and the link quality, or there is a correspondence relationship between a pair of a transmitting beam and a receiving beam and the link quality. Based on this situation, there is a correspondence relationship between any two of the at least one receiving beam index, the at least one transmitting beam index and the at least one link quality in the solution described above.

In some optional implementations, the correspondence relationship is determined by a sort of the at least one receiving beam index, a sort of the at least one transmitting beam index, and a sort of the at least one link quality.

As an example, the first sub-model on the UE side outputs K optimal receiving beam indexes, and the second sub-model on the network device side outputs K optimal transmitting beam indexes and K link qualities. The K optimal receiving beam indexes are denoted as {n1, n2, ..., nK}, the K optimal transmitting beam indexes are denoted as {m1, m2, ..., mK}, and the K link qualities are denoted as {r1, r2, ..., rK}. Optionally, the link qualities may be sorted in an order from high qualities to low qualities, i.e., {r1>r2>...>rK}. There are one-to-one correspondence relationships between the K optimal receiving beam indexes, the K optimal transmitting beam indexes, and the K link qualities; and a correspondence relationship is implicitly indicated by a sort of the K optimal receiving beam indexes, a sort of the K optimal transmitting beam indexes, and a sort of the K link qualities, that is, an optimal receiving beam index, an optimal transmitting beam index, and an link quality sorted at a same position are corresponding to each other. In a specific implementation, the K optimal receiving beam indexes output from the first sub-model on the UE side are sorted according to a sort of corresponding link qualities (e.g., in an order from high qualities to low qualities); the K optimal transmitting beam indexes output from the second sub-model on the network device side are sorted according to a sort of corresponding link qualities (e.g., in an order from high qualities to low qualities). In this way, the K optimal receiving beam indexes, the K optimal transmitting beam indexes, and the K link qualities may be represented as a triplet set, which is denoted as {(m1, n1, r1), (m2, n2, r2), ..., (mK, nK, rK)}, according to the correspondence relationship. It should be noted that there is no mutually exclusive relationship between the elements in {n1, n2, ..., nK}, that is, the optimal receiving beam indexes within the K optimal receiving beam indexes may be the same as or different from each other. Similarly, there is no mutually exclusive relationship between the elements in {m1, m2, ..., mK}, that is, the optimal transmitting beam indexes within the K optimal transmitting beam indexes may be the same as or different from each other; and there is a mutually exclusive relationship between the elements in {(m1, n1), (m2, n2), ..., (mK, nK)}, that is, a optimal beam pair within the K optimal beam pairs is different from others.

In the embodiments of the present application, an input of the first sub-model on the UE side is the link qualities of the multiple beams or the multiple beam pairs measured by the UE. An output of the first sub-model on the UE side includes the at least one receiving beam index and/or the uplink feedback information.

In a case where the output of the first sub-model on the UE side is the at least one receiving beam index, the first sub-model has one output layer, and the UE outputs at least one receiving beam index through the output layer.

In a case where the output of the first sub-model on the UE side is uplink feedback information, the first sub-model has an output layer, and the UE outputs first information through the output layer. The first information is used to determine the uplink feedback information. Further, the first sub-model further includes a quantization layer, and the UE performs quantization processing on the first information through the quantization layer to obtain the uplink feedback information.

In a case where the output of the first sub-model on the UE side includes the at least one receiving beam index and the uplink feedback information, the output layer of the first sub-model may be implemented as follows.

In a manner A, the first sub-model includes an output layer. The UE performs processing on the link qualities of the multiple beams or the multiple beam pairs by utilizing the first sub-model, outputs the at least one receiving beam index through a first part of nodes of the output layer, and outputs the first information through a second part of the nodes of the output layer. The first information is used to determine the uplink feedback information. Further, the first sub-model further includes a quantization layer, and the UE performs quantization processing on the first information through the quantization layer to obtain the uplink feedback information.

In a manner B, the first sub-model includes a first output layer and a second output layer. The UE performing process on the link qualities of the multiple beams or the multiple beam pairs by utilizing the first sub-model, outputs the at least one receiving beam index through the first output layer, and outputs first information through the second output layer. The first information is used to determine uplink feedback information. Further, the first sub-model further includes a quantization layer, and the UE performs quantization processing on the first information through the quantization layer to obtain the uplink feedback information.

Here, in the first sub-model, the first output layer is adjacent to the second output layer, or the first output layer is separated from the second output layer by at least one neural network layer.

Here, in the first sub-model, the first output layer is located in front of the second output layer, or the first output layer is located behind the second output layer.

In a solution B-1), in some optional implementations, in a case where the first output layer is located in front of the second output layer, the second output layer is a last neural network layer of the first sub-model, and the first output layer is a middle neural network layer of the first sub-model.

Here, the first output layer may be the whole or a portion of the middle neural network layer of the first sub-model. Taking a deep neural network as an example, the middle neural network layer of the first sub-model refers to a hidden layer.

In a solution B-2), in some optional implementations, in a case where the first output layer is located behind the second output layer, the first output layer is a last neural network layer of the first sub-model, and the second output layer is a middle neural network layer of the first sub-model.

Here, the second output layer may be the whole or a portion of the middle neural network layer of the first sub-model. Taking a deep neural network as an example, the middle neural network layer of the first sub-model refers to a hidden layer.

In a solution B-3), in some optional implementations, in a case where the first output layer is located behind the second output layer, the first output layer is a last neural network layer of the first sub-model, and the second output layer is a first neural network layer of the first sub-model.

Here, the second output layer may be the whole of the first neural network layer. Taking a deep neural network as an example, the first neural network layer of the first sub-model refers to an input layer, and an input of the first neural network layer is the link qualities of the multiple beams or the multiple beam pairs.

In the solutions described above, there is an association between the first output layer and the second output layer, or there is no association between the first output layer and the second output layer.

Here, the meaning that there is the association between the first output layer and the second output layer is that there is an association between the nodes of the first output layer and the nodes of the second output layer. Here, there being the association between the nodes of the first output layer and the nodes of the second output layer means that: there is an association between the outputs of the nodes of the first output layer and the inputs of the nodes of the second output layer (which is for a case where the first output layer is located in front of the second output layer), or there is an association between the outputs of the nodes of the second output layer and the inputs of the nodes of the first output layer (which is for a case where the second output layer is located in front of the first output layer). It should be noted that this kind of association may be a direct association (corresponding to a case where the two layers are adjacent) or an indirect association (corresponding to a case where the two layers are not adjacent). In addition, there may be an association between all or a portion of the nodes of the first output layer and all or a portion of the nodes of the second output layer.

In the embodiments of the present application, the uplink feedback information obtained by the UE after the quantization processing is performed though the quantization layer may be a bit sequence.

In some optional implementations, for the cases of the solution A, solution B-1) and solution B-2) described above, the uplink feedback information is a first bit sequence, and the first bit sequence is used to determine the at least one transmitting beam index and at least one link quality corresponding to the at least one transmitting beam index.

In some optional implementations, for the solution B-3) described above, the uplink feedback information is a second bit sequence, and the second bit sequence is used to indicate the link qualities of the multiple beams or the multiple beam pairs. The link qualities of the multiple beams or the multiple beam pairs are used to determine the at least one transmitting beam index and the at least one link quality corresponding to the at least one transmitting beam index.

In some optional implementations, in a case where the at least one receiving beam index is one receiving beam index, the UE receives downlink transmission by adopting a receiving beam indicated by the one receiving beam index.

In some optional implementations, in a case where the at least one transmitting beam index is one transmitting beam index, the network device sends the downlink transmission by adopting a transmitting beam indicated by the one transmitting beam index.

In some optional implementations, in a case where the at least one receiving beam index includes multiple receiving beam indexes, the UE determines a first receiving beam index from the multiple receiving beam indexes to receive the downlink transmission by adopting a receiving beam indicated by the first receiving beam index.

Here, the UE receives first indication information sent from the network device, where the first indication information is used to indicate a first transmitting beam index adopted by the network device; and the UE determines a first receiving beam index corresponding to the first transmitting beam index based on the correspondence relationship between the at least one receiving beam index and the at least one transmitting beam index. Optionally, the first indication information is carried in an MAC CE or DCI.

In some optional implementations, in a case where the at least one transmitting beam index includes multiple transmitting beam indexes, the network device selects a first transmitting beam index from the multiple transmitting beam indexes to send the downlink transmission by adopting a transmitting beam indicated by the first transmitting beam index.

Here, the network device sends the first indication information to the UE, where the first indication information is used to indicate a first transmitting beam index adopted by the network device. Optionally, the first indication information is carried in the MAC CE or DCI.

The first sub-model in the solutions described above is pre-trained, and the network device may train the first sub-model and issue a trained first sub-model to the UE.

Similarly, the second sub-model in the solutions described above is also pre-trained, and the second sub-model may be trained by the network device.

Of course, the first sub-model and/or the second sub-model are not limited to being trained by the network device, but the first sub-model and/or the second sub-model may also be trained by other devices with processing capabilities.

In some optional implementations, the network device training the first sub-model and/or the second sub-model includes: reporting, by the UE, a data set to the network device; receiving, by the network device, the data set reported from the UE; and training, by the network device, the first sub-model and/or the second sub-model by utilizing the data set, where the first sub-model is used for the UE to determine the at least one receiving beam index and/or the uplink feedback information based on link qualities of multiple beams or multiple beam pairs, and the second sub-model is used for the network device to determine the at least one transmitting beam index and/or the at least one link quality corresponding to the at least one transmitting beam index based on the uplink feedback information.

Here, the data set reported from the UE to the network device is used for the network device to train the first sub-model and/or the second sub-model.

As an implementation, in a case where the data set is used for the network device to train the first sub-model or train the first sub-model and the second sub-model (or in other words, the network trains the first sub-model or trains the first sub-model and the second sub-model by utilizing the data set), the network device issues a trained first sub-model to the UE; and the UE receives the trained first sub-model issued from the network device.

In some optional implementations, the data set includes:
input data of the first sub-model, where the input data includes link qualities of at least portion of beams or beam pairs in a first set of beams or beam pairs;
a label of output data of the first sub-model, where the label includes indexes of K receiving beams with a best link quality in the first set of beams or beam pairs; and
a label of output data of the second sub-model, where the label includes indexes of K transmitting beams with a best link quality and corresponding K link qualities in the first set of beams or beam pairs, and K is a positive integer.

Here, the first set of beams or the beam pairs refers to a first beam set or a first beam pair set. Here, the first beam set includes all transmitting beams or all receiving beams, e.g., all transmitting beams of the network device or all receiving beams of the UE. The first beam pair set includes all pairs of transmitting beams and receiving beams, i.e., the pairs of transmitting beams and receiving beams formed by all possible combinations of all receiving beams of the UE and all transmitting beams of the network device.

In the embodiments of the present application, the first sub-model and the second sub-model are trained jointly; or the first sub-model and the second sub-model are trained independently.

Here, during a process of jointly training the first sub-model and the second sub-model, the first sub-model and the second sub-model share a same loss function. The loss function may be understood as a joint loss function of the first sub-model and the second sub-model, and weights of the two sub-models are co-optimized through the joint loss function. Specifically, a loss value between output data and a label of a whole model is calculated through the joint loss function to determine whether the loss value meets a preset condition. If the loss value does not meet the preset condition, the first sub-model and the second sub-model are updated according to the loss value (including but not limited to updating the weights of the first sub-model and the second sub-model), and the steps described above are continuously iterated until the loss value meets the preset condition, and the joint training of the first sub-model and the second sub-model is completed. Here, the output data of the whole model includes indexes of K receiving beams, indexes of K transmitting beams, and corresponding K link qualities.

Here, during a process of independent training the first sub-model and the second sub-model, the first sub-model and the second sub-model have independent loss functions, and the weights of the two sub-models are optimized respectively through the two loss functions. Specifically, a loss value between output data of the first sub-model and a label of the output data of the first sub-model is calculated through a first loss function, and whether the loss value meets a preset condition is determined. If the loss value does not meet the preset condition, the first sub-model is updated according to the loss value (including but not limited to updating the weight of the first sub-model), and the steps described above are continuously iterated until the loss value meets the preset condition and the training of the first sub-model is completed. Similarly, a loss value between output data of the second sub-model and a label of the output data of the second sub-model is calculated through a second loss function, and whether the loss value meets a preset condition is determined. If the loss value does meet the preset condition, the second sub-model is updated according to the loss value (including but not limited to updating the weight of the second sub-model), and the steps described above are continuously iterated until the loss value meets the preset condition and the training of the second sub-model is completed. Here, the output data of the first sub-model includes indexes of K receiving beams, and the output data of the second sub-model includes indexes of K transmitting beams and corresponding K link qualities.

In some optional implementations, for the solution A, the solution B-1) and the solution B-2) described above, since the input of the second sub-model (i.e., the uplink feedback information) is obtained after the first sub-model performs processing (referring to processing except processing with the quantization layer herein) on the link qualities of the multiple beams or the multiple beam pairs, the second sub-model and the first sub-model need to be paired for training, that is, the first sub-model and the second sub-model need to be trained jointly. In addition, for this case, the first sub-model and the second sub-model also need to be deployed in pairs.

In some optional implementations, for the case of the solution B-3) described above, since the input of the second sub-model (i.e., the uplink feedback information) is obtained without performing processing (referring to processing except processing with the quantization layer herein) on the link qualities of the multiple beams or the multiple beam pairs by the first sub-model, the second sub-model and the first sub-model do not need to be paired for training, and the first sub-model and the second sub-model may be trained independently. In addition, for this case, the first sub-model and the second sub-model may also be deployed independently.

In the technical solution of the embodiments of the present application, AI/ML-based beam management is realized, and trained neural networks are deployed on the network device side and/or the UE side respectively. The beam management process includes at least one of: a UE measurement process, a UE inference (i.e., prediction) process, and a process of UE reporting and network device inference (i.e., prediction). For the UE measurement process, the UE measures a portion of beams or beam pairs of all beams or beam pairs; for the UE inference (i.e., prediction) process, the UE predicts an optimal receiving beam index and/or uplink feedback information through a local neural network (i.e., the first sub-model) according to a measurement result; for the UE reporting and network device inference (i.e., prediction) process, the UE reports the uplink feedback information to the network device, and the network device predicts an optimal transmitting beam and a corresponding link quality through a local neural network (i.e., the second sub-model) according to the uplink feedback information. Through this solution, the network device and the UE can select beams or beam pairs with a better channel quality, and a large amount of overhead and delay generated during the beam scanning is reduced.

All or a portion of the technical solutions described above in the embodiments of the present application are explained and described below in connection with specific instances.

It should be noted that the following instances are described by taking a "beam pair" as an example, where the beam pair refers to a pair of a transmitting beam and a receiving beam.

It should be noted that the following instances are described by taking the link quality as "L1-RSRP" as an example, which is certainly not limited thereto, and the link quality may also be L1-SINR and L1-RSRQ.

It should be noted that a network (NW) in the following instances corresponds to the "network device" in the solutions described above.

### First Enstance

In this instance, models are deployed separately on a UE side and an NW side. As shown in FIG. 8, the models (a part included in a dotted box) include a UE-side sub-model (i.e., a first sub-model) and an NW-side sub-model (i.e., a second sub-model), where an input of the UE-side sub-model is a L1-RSRP of a measured beam pair by the UE, and the measured beam pair is a subset of all beam pairs. Here, all beam pairs refer to all pairs of transmitting beams and receiving beams, that is, the pairs of transmitting beams and receiving beams formed by all possible combinations of all receiving beams of the UE and all transmitting beams of the NW. The UE-side sub-model outputs K optimal receiving beam indexes while the UE-side outputs uplink feedback information. The uplink feedback information may be reported to the NW side through an MAC CE (corresponding to PUSCH) or DCI (corresponding to PDCCH). An input of the NW-side sub-model is the uplink feedback information, and an output of the NW-side sub-model includes K optimal transmitting beam indexes and L1-RSRPs corresponding to the K optimal transmitting beam indexes, where K is a positive integer.

### Case 1) K = 1

The UE-side sub-model outputs one optimal receiving beam index, and the NW-side sub-model outputs one optimal transmitting beam index and an L1-RSRP corresponding to the optimal transmitting beam index.

In this case, the UE selects the one optimal receiving beam output by the UE-side sub-model for receiving downlink transmission, and the NW selects the one optimal transmitting beam output by the NW-side sub-model for sending the downlink transmission. Here, matching of an optimal beam pair is achieved automatically through an optimal receiving beam indicated by the one optimal receiving beam index output by the UE-side sub-model and an optimal transmitting beam indicated by the one optimal transmitting beam index output by the NW-side sub-model without indicating for which beams can be used by the UE side and the NW side. A link quality of the optimal beam pair is given through the L1-RSRP output by the NW-side sub-model.

### Case 2) K > 1

The UE-side sub-model outputs K (K>1) optimal receiving beam indexes, and the NW-side sub-model outputs K optimal transmitting beam indexes and L1-RSRPs corresponding to the K optimal transmitting beam indexes.

In this case, there is a one-to-one pairing implicit relationship between the K optimal receiving beam indexes (represented by a symbol of n herein) output by the UE-side sub-model and the K optimal transmitting beam indexes (represented by a symbol of m herein) and the L1-RSRPs (represented by a symbol of r herein) output by the NW-side sub-model, that is, K beam pairs and corresponding L1-RSRPs may be represented as a triplet set: {(m1, n1, r1), (m2, n2, r2), ..., (mK, nK, rK)}, where {m1, m2, ..., mK} represent K optimal transmitting beam indexes, {n1, n2, ..., nK} represent K optimal receiving beam indexes, and {r1, r2, ..., rK} represent L1-RSRPs corresponding to the K optimal transmitting beam indexes. Optionally, {r1>r2>...>rK}. A pairing relationship (i.e., a correspondence relationship) between the optimal transmitting beam index and the optimal receiving beam index is implicitly indicated in an order of a beam index sequence output by the UE-side sub-model and the NW-side sub-model, rather than explicitly indicated by the uplink feedback information, that is, the K optimal receiving beam indexes output by the UE-side sub-model and the K optimal transmitting beam indexes output by the NW-side sub-model are sorted in descending order with corresponding L1-RSRPs.

### Second Instance

In this instance, structures of the UE-side sub-model (i.e., the first sub-model) may be implemented in multiple manners. Structures of several UE-side sub-models are given below. It should be noted that this instance adopts an implementation of a deep neural network to describe the structures of the UE-side sub-model, which is however not limited to thereto. Other implementation manners such as a convolutional neural network, a recurrent neural network, etc., may also implement the structures of the UE-side sub-model. Implementation manners adopting other neural networks may be expanded based on this instance and adopting the same input/output interface.

As an implementation, as shown in FIG. 9-1, the UE-side sub-model includes an input layer, a hidden layer, and an output layer. First information and K optimal receiving beam indexes are output from the output layer in parallel and share all hidden layer weights. An input of the input layer is a matrix in which L1-RSRPs of measured M beam pairs are arranged in a specified order. The hidden layer is composed of multiple fully connected layers. The output layer is composed of two parts spliced together, K nodes of the output layer output K optimal receiving beam indexes, and other nodes of the output layer output the first information. The first information is output as uplink feedback information after passing through a quantization layer. After the uplink feedback information is reported to the NW side, the uplink feedback information serves as an input of the NW-side sub-model. Here, the uplink feedback information is a section of bit sequence. The bit sequence does not explicitly indicate the K optimal transmitting beam indexes and the L1-RSRPs corresponding to K optimal transmitting beam indexes, but implicitly includes information of the K optimal transmitting beam indexes and the L1-RSRPs corresponding to the K optimal transmitting beam indexes, and the information may be extracted by a matched NW-side sub-model. Therefore, the UE-side sub-model and the NW-side sub-model need to be paired for training and deployment, so that the NW can correctly predict the K optimal transmitting beam indexes and L1-RSRPs corresponding to the K optimal transmitting beam indexes from the uplink feedback information.

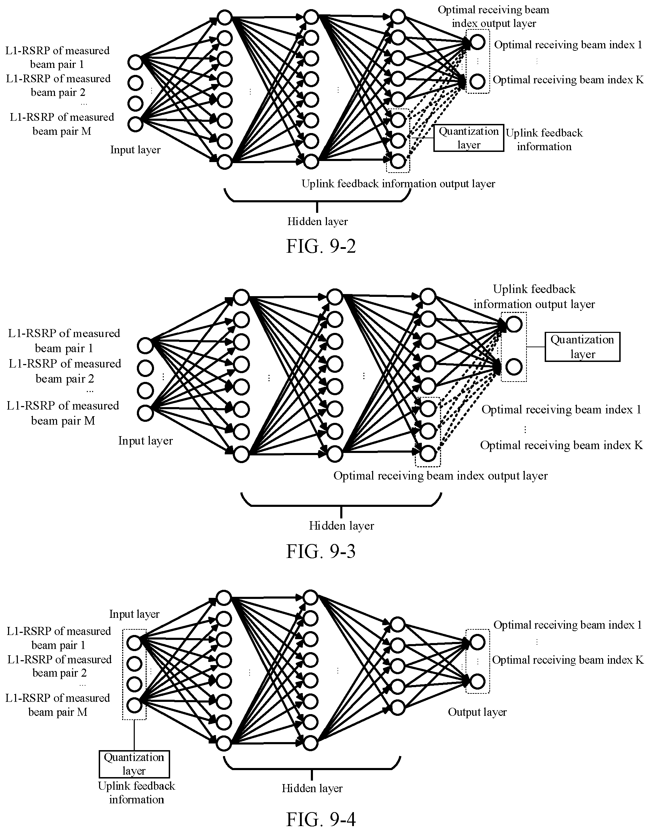

As an implementation, as shown in FIG. 9-2, the UE-side sub-model includes an input layer, a hidden layer, an uplink feedback information output layer, and an optimal receiving beam index output layer. The uplink feedback information output layer and the optimal receiving beam index output layer are not in a same layer, and only share a portion of hidden layer weights. An input of the input layer is a matrix in which L1-RSRPs of measured M beam pairs are arranged in a specified order. The hidden layer is composed of multiple fully connected layers. The uplink feedback information output layer is a portion of one neural network layer of the hidden layer, and the uplink feedback information output layer is in front of the optimal receiving beam index output layer. The optimal receiving beam index output layer outputs K optimal receiving beam indexes. The uplink feedback information output layer outputs first information, where the first information is output as uplink feedback information after passing through a quantization layer. After the uplink feedback information is reported to the NW side, the uplink feedback information serves as an input of the NW-side sub-model. Here, the uplink feedback information is a section of bit sequence. The bit sequence does not explicitly indicate K optimal transmitting beam indexes and L1-RSRPs corresponding to the K optimal transmitting beam indexes, but implicitly includes information of the K optimal transmitting beam indexes and L1-RSRPs corresponding to the K optimal transmitting beam indexes. The information may be extracted by a matched NW-side sub-model. Therefore, the UE-side sub-model and the NW-side sub-model need to be paired for training and deployment, so that the NW can correctly predict the K optimal transmitting beam indexes and the L1-RSRPs corresponding to the K optimal transmitting beam indexes from the uplink feedback information. It should be pointed out that although the uplink feedback information output layer in FIG. 9-2 is a portion of the one neural network layer of the hidden layer, which is however not limited thereto, and the uplink feedback information output layer may also be the whole of the one neural network layer of the hidden layer. Although the uplink feedback information output layer in FIG. 9-2 is adjacent to the optimal receiving beam index output layer, which is however not limited thereto, and the uplink feedback information output layer may also be separated from the optimal receiving beam index output layer by one or more neural network layers. In addition, the output of the uplink feedback information output layer may be used or may not be used (which is represented by dotted weight connection in FIG. 9-2) as a portion of implicit information for acquiring the K optimal receiving beam indexes.

As an implementation, as shown in FIG. 9-3, the UE-side sub-model includes an input layer, a hidden layer, an optimal receiving beam index output layer, and an uplink feedback information output layer. The optimal receiving beam index output layer and the uplink feedback information output layer are not in a same layer, and only share a portion of hidden layer weights. An input of the input layer is a matrix in which L1-RSRPs of measured M beam pairs are arranged in a specified order. The hidden layer is composed of multiple fully connected layers. The optimal receiving beam index output layer is a portion of one neural network layer of the hidden layer, and the optimal receiving beam index output layer is in front of the uplink feedback information output layer. The optimal receiving beam index output layer outputs K optimal receiving beam indexes, and the uplink feedback information output layer outputs first information. The first information is output as uplink feedback information after passing through a quantization layer. After the uplink feedback information is reported to the NW side, the uplink feedback information serves as an input of the NW-side sub-model. Here, the uplink feedback information is a section of bit sequence. The bit sequence does not explicitly indicate K optimal transmitting beam indexes and L1-RSRPs corresponding to the K optimal transmitting beam indexes, but implicitly includes information of the K optimal transmitting beam indexes and the L1-RSRPs corresponding to the K optimal transmitting beam indexes. The information may be extracted by a matched NW-side sub-model. Therefore, the UE-side sub-model and the NW-side sub-model need to be paired for training and deployment, so that the NW may correctly predict the K optimal transmitting beam indexes and the L1-RSRPs corresponding to the K optimal transmitting beam indexes from the uplink feedback information. It should be pointed out that although the optimal receiving beam index output layer in FIG. 9-3 is a portion of the one neural network layer of the hidden layer, which is however not limited thereto, and the optimal receiving beam index output layer may also be the whole of the one neural network layer of the hidden layer. Although the optimal receiving beam index output layer in FIG. 9-3 is adjacent to the uplink feedback information output layer, which is however not limited thereto, and the optimal receiving beam index output layer may also be separated from the uplink feedback information output layer by one or more neural network layers. In addition, an output of the optimal receiving beam index output layer may be used or not used (which is represented by dotted weight connection in FIG. 9-3) as a portion of implicit information for acquiring the uplink feedback information.

As an implementation, as shown in FIG. 9-4, the UE-side sub-model includes an input layer, a hidden layer, and an output layer. An input of the input layer is a matrix in which L1-RSRPs of measured M beam pairs are arranged in a specified order. The hidden layer is composed of multiple fully connected layers. An output layer outputs K optimal receiving beam indexes. The L1-RSRPs of the M beam pairs of the input layer are used as first information and are output as uplink feedback information after passing through a quantization layer. After the uplink feedback information is reported to the NW side, the uplink feedback information serves as an input of the NW-side sub-model. Since the uplink feedback information is directly acquired based on the L1-RSRPs of the M beam pairs for the input layer through the quantization layer, the uplink feedback information does not pass through any hidden layer for implicit feature extraction. The uplink feedback information is a section of bit sequence. The bit sequence explicitly indicates the L1-RSRPs of the measured M beam pairs and is directly reported to the NW side. The NW-side sub-model acquires, from the measured L1-RSRPs of the beam pairs, K optimal transmitting beam indexes and L1-RSRPs corresponding to the K optimal transmitting beam indexes. Therefore, the UE-side sub-model and the NW-side sub-model do not need a strict pairing relationship and may be trained and deployed independently. It should be noted that the input of the UE-side sub-model includes values of L1-RSRPs of direct measurement beam pairs, and there is no quantization error; while the input of the NW-side sub-model is acquired from the uplink feedback information, so there is a quantization error.

### Third Instance

In this instance, the UE-side sub-model and the NW-side sub-model are trained offline. That is, the sub-models deployed on the UE side and the NW side are models that have been adapted to a current cell or communication scenario.

During an offline training, a data set required by the model includes the following parts:
an input: L1-RSRPs of a portion of beam pairs of all beam pairs, where the all beam pairs here include pairs of transmitting beams and receiving beams formed by all possible combinations of all receiving beams of the UE and all transmitting beams of the network device; and
a label: indexes of K beam pairs with a highest L1-RSRP in all beam pairs (i.e., K optimal transmitting beam indexes and K optimal receiving beam indexes) and corresponding L1-RSRPs.

In addition, an output of the model is classified into the following two parts: an output of the UE-side sub-model and an output of the NW-side sub-model, where the output of the UE-side sub-model includes K optimal receiving beam indexes; and the output of the NW-side sub-model includes K optimal transmitting beam indexes and L1-RSRPs corresponding to the K optimal transmitting beam indexes.

It should be noted that if K optimal beam pairs are output, the model may infer a case of optimal beam pairs with a number less than K.

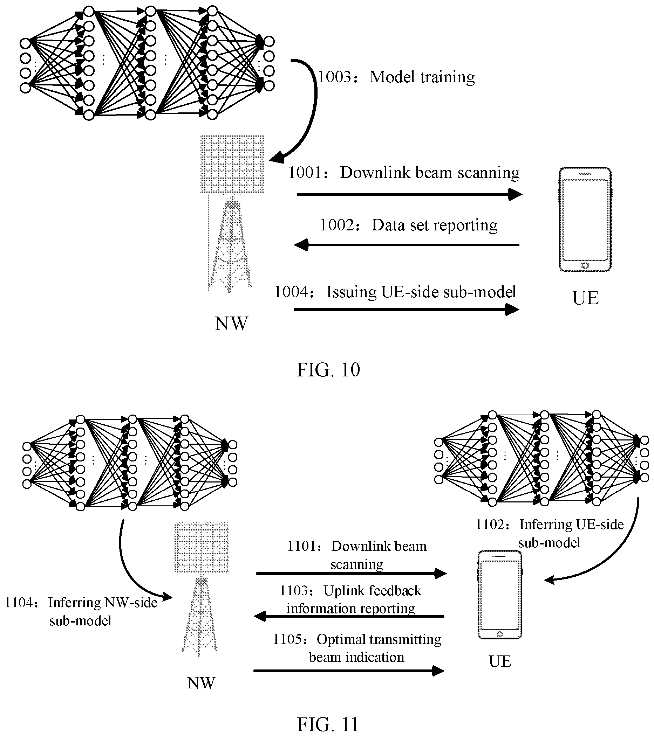

Considering that the NW has stronger computing power, an offline training task is completed on the NW side. Specifically, during the offline training process, the NW side saves complete structures of the UE-side sub-model and the NW-side sub-model, and issues a trained UE-side sub-model (specifically including structures and parameters of the UE-side sub-model) to the UE through a downlink channel after the training is completed. Specifically, the training process is shown in FIG. 10, and includes the following steps.

In step 1001, the NW performs downlink beam scanning.

Here, when the NW performs the downlink beam scanning, the NW scans all downlink beams (i.e., all transmitting beams of the network device), such as beams used for 64 SSBs/CSI-RSes. For each downlink beam (i.e., a transmitting beam), the UE traverses all receiving beams to measure a L1-RSRP, and finally acquires L1-RSRPs of all beam pairs. The UE determines indexes of K beam pairs with a highest L1-RSRP (i.e., K optimal transmitting beam indexes and K optimal receiving beam indexes) and corresponding K L1-RSRPs according to L1-RSRPs of all beam pairs.

In step 1002, a UE reports a data set.

Here, the data set includes the following two parts: a first part as an input, i.e., an input of the UE-side sub-model, specifically L1-RSRPs of a portion of beam pairs of all measured beam pairs; and a second part as a label, i.e., labels of the UE-side sub-model and the NW-side sub-model, specifically K optimal transmitting beam indexes, K optimal receiving beam indexes and corresponding K L1-RSRPs.

In step 1003, the NW trains a UE-side sub-model and an NW-side sub-model according to the data set reported from the UE.

Here, for structures of some UE-side sub-models (e.g., the structures shown in FIGS. 9-1 to 9-3), uplink feedback information is obtained by processing of the UE-side sub-model and used as an input of the NW-side sub-model. Therefore, the UE-side sub-model and the NW-side sub-model must be trained jointly to ensure the matching of the UE-side sub-model with the NW sub-model. For structures of other UE-side sub-models (e.g., the structures shown in FIG. 9-4), the UE-side sub-model and the NW-side sub-model share the input layer, and the UE-side sub-model and the NW-side sub-model may be trained separately without strict model matching.

In step 1004, the NW issues a UE-side sub-model.

Here, the NW issues a trained UE-side sub-model to the UE through a downlink channel to complete online deployment for the model. Afterwards, the NW and the UE may implement AI/ML-based beam management according to the aforementioned relevant solutions.

### Fourth Instance

In this instance, based on an NW-side sub-model and a UE-side sub-model trained offline and deployed online, an online inference method is adopted to implement AI/ML-based beam management to obtain K optimal receiving beam indexes, K optimal transmitting beam indexes, and L1-RSRPs corresponding to the K optimal transmitting beam indexes, where K is a positive integer. In addition, this instance further gives an AI/ML-based beam indication method, in which the NW side and the UE side are assisted to cooperate with matching the optimal transmitting beam and the optimal receiving beam through necessary signaling support.

### Case 1) K = 1

The UE-side sub-model outputs one optimal receiving beam index, and the NW-side sub-model outputs one optimal transmitting beam index and an L1-RSRP corresponding to the optimal transmitting beam index.

In this case, the UE selects the one optimal receiving beam output by the UE-side sub-model for receiving downlink transmission, and the NW selects the one optimal transmitting beam output by the NW-side sub-model for sending downlink transmission. Here, matching of an optimal beam pair is achieved automatically through an optimal receiving beam indicated by the optimal receiving beam index output by the UE-side sub-model and an optimal transmitting beam indicated by the optimal transmitting beam index output by the NW-side sub-model without indicating for which beams can be used by the UE side and the NW side.

### Case 2) K > 1

The UE-side sub-model outputs K (K>1) optimal receiving beam indexes, and the NW-side sub-model outputs K optimal transmitting beam indexes and L1-RSRPs corresponding to the K optimal transmitting beam indexes.

In this case, the NW selects one optimal transmitting beam index from K optimal transmitting beam indexes, and sends downlink transmission by utilizing an optimal transmitting beam indicated by the one optimal transmitting beam index. The NW indicates a used optimal transmitting beam index to the UE. The UE may select an optimal receiving beam index that matches the optimal transmitting beam index used by the NW according to a correspondence relationship between the optimal transmitting beam index and the optimal receiving beam index, and then receives the downlink transmission by utilizing an optimal receiving beam indicated by the optimal receiving beam index. Here, the NW may indicate the optimal transmitting beam index used by the NW through an MAC CE or DCI. For K optimal receiving beam indexes, if one optimal receiving beam index is expected to be indicated from K optimal receiving beam indexes, log₂K bits are required for indication. For example, when K=4, 2 bits are required for indication. Specifically, the beam indication process is shown in FIG. 11 and includes the following steps.

In step 1101, an NW performs downlink beam scanning.

Here, when performing downlink beam scanning, the NW scans all or a portion of downlink beams (i.e., all or a portion of the transmitting beams of the network device). The UE measures L1-RSRPs for all or a portion of the downlink beams (i.e., the transmitting beams) by traversing all or a portion of the receiving beams, and finally acquires L1-RSRPs of a portion of beam pairs of all the beam pairs.

In step 1102, the UE-side sub-model performs inference.

Here, the UE infers (i.e., predicts) K optimal receiving beam indexes and uplink feedback information through the UE-side sub-model according to the L1-RSRPs of the portion of beam pairs.

In step 1103, the UE reports uplink feedback information.

In step 1104, the NW-side sub-model performs inference.

Here, the NW infers (i.e., predicts) K optimal transmitting beam indexes and corresponding K L1-RSRPs through the NW-side sub-model according to the uplink feedback information. In a case of K>1, the NW selects one optimal transmitting beam index, as the transmitting beam index for downlink transmission, from the K optimal transmitting beam indexes.

In step 1105, the NW indicates an optimal transmitting beam index to the UE.

Here, the UE determines a corresponding optimal receiving beam index according to the optimal transmitting beam index indicated by the NW, and receives the downlink transmission by utilizing the receiving beam indicated by the optimal receiving beam index.

The preferred implementations of the present application are described in detail above in connection with the accompanying drawings. However, the present application is not limited to the specific details in the implementations described above. Within the scope of the technical concept of the present application, a variety of simple modifications may be made to the technical solutions of the present application, and these simple modifications all fall within the protection scope of the present application. For example, the various specific technical features described in the specific embodiments described above may be combined in any suitable manner without conflict. In order to avoid unnecessary repetition, the various possible combinations are not otherwise described in the present application. As another example, any combination between the various different embodiments of the present application is also possible, as long as they are not inconsistent with the idea of the present application, they should also be regarded as the content disclosed in the present application. As another example, under the premise of no conflict, the various embodiments and/or the technical features in the various embodiments described in the present application may be arbitrarily combined with the prior art, and the technical solution obtained after the combination should also fall within the protection scope of the present application.

It should also be understood that in the various method embodiments of the present application, the size of the serial numbers of the processes described above does not mean an order of execution. The execution order of each process should be determined by its function and internal logic, and should not constitute any limitation on the implementation process of the embodiments of the present application. In addition, in the embodiments of the present application, the terms "downlink", "uplink" and "sidelink" are used to represent the transmission direction of signals or data, where "downlink" is used to represent that the transmission direction of signals or data is a first direction from a site to a user equipment of a cell, "uplink" is used to represent that the transmission direction of signals or data is a second direction from a user equipment of a cell to a site, and "sidelink" is used to represent that the transmission direction of signals or data is a third direction from user equipment 1 to user equipment 2. For example, a "downlink signal" represent that the transmission direction of the signal is the first direction. In addition, in the embodiments of the present application, the term "and/or" is merely used to describe the association relationship between associated objects, representing that three types of relationships may exist. Specifically, A and/or B may mean three cases where: A exists alone, both A and B exist, and B exists alone. In addition, a character "/" herein generally means that associated objects before and after *"*/*"* are in an "or" relationship.

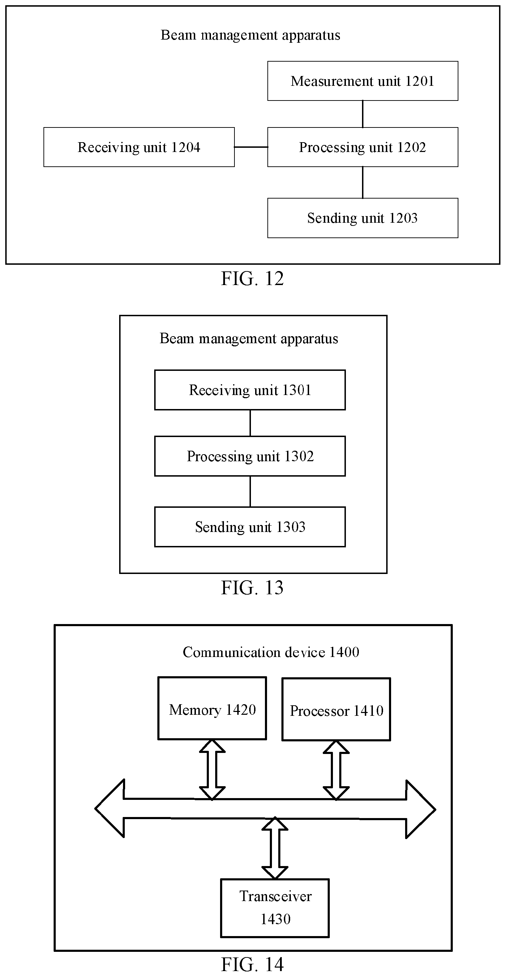

FIG. 12 is a first structural diagram of structures of a beam management apparatus provided in the embodiments of the present application, which is applied to a user equipment. As shown in FIG. 12, the beam management apparatus includes:
a measurement unit 1201, configured to measure link qualities of multiple beams or multiple beam pairs; and
a processing unit 1202, configured to determine at least one receiving beam index and/or uplink feedback information by utilizing a first sub-model based on the link qualities of the multiple beams or the multiple beam pairs, where the uplink feedback information is used to determine at least one transmitting beam index and/or at least one link quality corresponding to the at least one transmitting beam index.

In some optional implementations, the apparatus further includes: a sending unit 1203, configured to send the uplink feedback information to a network device, where the uplink feedback information is used for the network device to determine the at least one transmitting beam index and/or the at least one link quality corresponding to the at least one transmitting beam index by utilizing a second sub-model.

In some optional implementations, the multiple beams are multiple receiving beams or multiple transmitting beams, and the multiple beam pairs are multiple pairs of transmitting beam and receiving beam.

In some optional implementations, the at least one receiving beam index includes indexes of K receiving beams with a best link quality in the multiple beams or the multiple beam pairs, where K is a positive integer.

In some optional implementations, the at least one transmitting beam index includes indexes of K transmitting beams with a best link quality in the multiple beams or the multiple beam pairs, where K is a positive integer.

In some optional implementations, there is a correspondence relationship between any two of the at least one receiving beam index, the at least one transmitting beam index, and the at least one link quality.

In some optional implementations, the correspondence relationship is determined by a sort of the at least one receiving beam index, a sort of the at least one transmitting beam index, and a sort of the at least one link quality.

In some optional implementations, the first sub-model includes an output layer; and the processing unit 1202 is configured to perform processing on the link qualities of the multiple beams or the multiple beam pairs by utilizing the first sub-model to output at least one receiving beam index through a first part of nodes of the output layer, and output first information through a second part of the nodes of the output layer, where the first information is used to determine the uplink feedback information.

In some optional implementations, the first sub-model includes a first output layer and a second output layer; and the processing unit 1202 is configured to perform processing on the link qualities of the multiple beams or the multiple beam pairs by utilizing the first sub-model to output at least one receiving beam index through the first output layer, and output first information through the second output layer, where the first information is used to determine the uplink feedback information.

In some optional implementations, in the first sub-model, the first output layer is adjacent to the second output layer, or the first output layer is separated from the second output layer by at least one neural network layer.

In some optional implementations, in the first sub-model, the first output layer is located in front of the second output layer, or the first output layer is located behind the second output layer.

In some optional implementations, in a case where the first output layer is located in front of the second output layer, the second output layer is a last neural network layer of the first sub-model; and the first output layer is a middle neural network layer of the first sub-model.

In some optional implementations, in a case where the first output layer is located behind the second output layer, the first output layer is a last neural network layer of the first sub-model; and the second output layer is a middle neural network layer of the first sub-model.

In some optional implementations, in a case where the first output layer is located behind the second output layer, the first output layer is a last neural network layer of the first sub-model; and the second output layer is a first neural network layer of the first sub-model.

In some optional implementations, an input of the first neural network layer includes the link qualities of the multiple beams or the multiple beam pairs.

In some optional implementations, there is an association between the first output layer and the second output layer, or there is no association between the first output layer and the second output layer.

In some optional implementations, the first sub-model further includes a quantization layer, and the processing unit 1202 is configured to perform quantization processing on the first information through the quantization layer to obtain the uplink feedback information.

In some optional implementations, the uplink feedback information is a first bit sequence, and the first bit sequence is used to determine the at least one transmitting beam index and the at least one link quality corresponding to the at least one transmitting beam index.

In some optional implementations, the uplink feedback information is a second bit sequence, where the second bit sequence is used to indicate the link qualities of the multiple beams or the multiple beam pairs, and the link qualities of the multiple beams or the multiple beam pairs are used to determine the at least one transmitting beam index and the at least one link quality corresponding to the at least one transmitting beam index.

In some optional implementations, the apparatus further includes: a receiving unit 1204, configured to receive downlink transmission by adopting a receiving beam indicated by one receiving beam index in a case where the at least one receiving beam index is the one receiving beam index.

In some optional implementations, the apparatus further includes: a receiving unit 1204, configured to determine a first receiving beam index from the multiple receiving beam indexes in a case where the at least one receiving beam index includes multiple receiving beam indexes, and receive downlink transmission by adopting a receiving beam indicated by the first receiving beam index.

In some optional implementations, the receiving unit 1204 is configured to receive first indication information sent from a network device, where the first indication information is used to indicate a first transmitting beam index adopted by the network device; and determine a first receiving beam index corresponding to the first transmitting beam index based on a correspondence relationship between the at least one receiving beam index and the at least one transmitting beam index.

In some optional implementations, the first indication information is carried in an MAC CE or DCI.

In some optional implementations, the sending unit 1203 is configured to report a data set to the network device, where the data set is used for the network device to train the first sub-model; and the receiving unit 1204 is configured to receive a trained first sub-model sent from the network device.

In some optional implementations, the data set is further used for the network device to train a second sub-model, where the second sub-model is used for the network device to determine the at least one transmitting beam index and/or at least one link quality corresponding to the at least one transmitting beam index based on the uplink feedback information.

In some optional implementations, the first sub-model and the second sub-model are trained jointly; or, the first sub-model and the second sub-model are trained independently.

In some optional implementations, the data set includes:
input data of the first sub-model, where the input data includes link qualities of at least portion of beams or beam pairs in a first set of beams or beam pairs;
a label of output data of the first sub-model, where the label includes indexes of K receiving beams with a best link quality in the first set of beams or beam pairs; and
a label of output data of the second sub-model, where the label includes indexes of K transmitting beams with a best link quality in the first set of beams or beam pairs and corresponding K link qualities, and K is a positive integer.

In some optional implementations, a link quality includes at least one of: a L1-RSRP, a L1-SINR, or a L1-RSRQ.

Those skilled in the art should understand that the relevant description of the beam management apparatus described above in the embodiments of the present application may be understood by referring to the relevant description of the beam management method in the embodiment of the present application.

FIG. 13 is a second schematic diagram of structures of a beam management apparatus provided in the embodiments of the present application, which is applied to a network device. As shown in FIG. 13, the beam management device includes:
a receiving unit 1301, configured to receive uplink feedback information sent from a UE; and
a processing unit 1302, configured to determine at least one transmitting beam index and/or at least one link quality corresponding to the at least one transmitting beam index by utilizing a second sub-model based on the uplink feedback information.

In some optional implementations, the uplink feedback information is a first bit sequence, where the first bit sequence is used to determine the at least one transmitting beam index and the at least one link quality corresponding to the at least one transmitting beam index.

In some optional implementations, the uplink feedback information is a second bit sequence, where the second bit sequence is used to indicate link qualities of multiple beams or multiple beam pairs, and the link qualities of the multiple beams or the multiple beam pairs are used to determine the at least one transmitting beam index and the at least one link quality corresponding to the at least one transmitting beam index.

In some optional implementations, the apparatus further includes: a sending unit 1303, configured to send downlink transmission by adopting a transmitting beam indicated by one transmitting beam index in a case where the at least one transmitting beam index is the one transmitting beam index.

In some optional implementations, the apparatus further includes: a sending unit 1303, configured to select a first transmission beam index from multiple transmission beam indexes in a case where the at least one transmission beam index includes the multiple transmission beam indexes to send downlink transmission by adopting a transmission beam indicated by the first transmission beam index.

In some optional implementations, the sending unit 1303 is configured to send first indication information to the UE, where the first indication information is used to indicate a first transmitting beam index adopted by the network device.

In some optional implementations, the first indication information is carried in an MAC CE or DCI.

In some optional implementations, the receiving unit 1301 is configured to receive a data set reported from the UE; and the processing unit 1302 is configured to train the second sub-model by utilizing the data set.

In some optional implementations, the data set is further used for the network device to train a first sub-model, where the first sub-model is used for the UE to determine at least one receiving beam index and/or uplink feedback information based on link qualities of multiple beams or multiple beam pairs.

In some optional implementations, the at least one receiving beam index includes indexes of K receiving beams with a best link quality in the multiple beams or the multiple beam pairs, where K is a positive integer.

In some optional implementations, the at least one transmitting beam index includes indexes of K transmitting beams with a best link quality in the multiple beams or the multiple beam pairs, where K is a positive integer.

In some optional implementations, there is a correspondence relationship between any two of the at least one receiving beam index, the at least one transmitting beam index, and the at least one link quality.

In some optional implementations, the correspondence relationship is determined by a sort of the at least one receiving beam index, a sort of the at least one transmitting beam index, and a sort of the at least one link quality.

In some optional implementations, the first sub-model and the second sub-model are trained jointly; or, the first sub-model and the second sub-model are trained independently.

In some optional implementations, the sending unit 1303 is configured to send a trained first sub-model to the UE.

In some optional implementations, the data set includes:
input data of the first sub-model, where the input data is link qualities of at least portion of beams or beam pairs in a first set of beams or beam pairs;
a label of output data of the first sub-model, where the label includes indexes of K receiving beams with a best link quality in the first set of beams or beam pairs; and
a label of output data of the second sub-model, where the label includes indexes of K transmitting beams with a best link quality in the first set of beams or beam pairs and corresponding K link qualities, where K is a positive integer.

In some optional implementations, a link quality includes at least one of: a L1-RSRP, a L1-SINR, or a L1-RSRQ.

Those skilled in the art should understand that the relevant description of the beam management apparatus described above in the embodiments of the present application may be understood by referring to the relevant description of the beam management method in the embodiments of the present application.

FIG. 14 is a schematic structural diagram of a communication device 1400 provided in the embodiments of the present application. The communication device may be a user equipment or a network device. The communication device 1400 shown in FIG. 14 includes a processor 1410, and the processor 1410 may invoke and execute a computer program from a memory to implement the methods in the embodiments of the present application.

Optionally, as shown in FIG. 14, the communication device 1400 may further include a memory 1420. The processor 1410 may invoke and execute a computer program from the memory 1420 to implement the methods in the embodiments of the present application.

The memory 1420 may be a separate device independent from the processor 1410, or may be integrated into the processor 1410.

Optionally, as shown in FIG. 14, the communication device 1400 may further include a transceiver 1430, and the processor 1410 may control the transceiver 1430 to communicate with other devices, specifically, to send information or data to other devices, or to receive information or data sent from other devices.

Herein, the transceiver 1430 may include a transmitter and a receiver. The transceiver 1430 may further include an antenna, and a number of antennas may be one or more.

Optionally, the communication device 1400 may specifically be a network device in the embodiments of the present application, and the communication device 1400 may implement corresponding procedures implemented by the network device in respective methods in the embodiments of the present application, which will not be repeated herein for the sake of brevity.

Optionally, the communication device 1400 may specifically be a user equipment in the embodiments of the present application, and the communication device 1400 may implement the corresponding procedures implemented by the user equipment in respective methods in the embodiments of the present application, which will not be repeated herein for the sake of brevity.

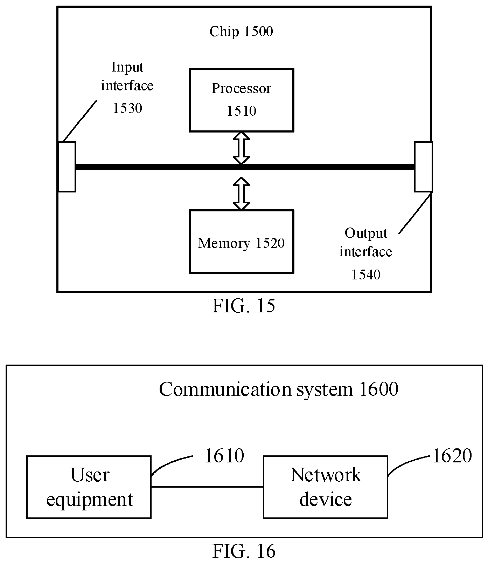

FIG. 15 is a schematic structural diagram of a chip in the embodiments of the present application. The chip 1500 shown in FIG. 15 includes a processor 1510, and the processor 1510 may invoke and execute a computer program from a memory to implement the methods in the embodiments of the present application.

Optionally, as shown in FIG. 15, the chip 1500 may further include a memory 1520. The processor 1510 may invoke and execute a computer program from the memory 1520 to implement the methods in the embodiments of the present application.

The memory 1520 may be a separate device independent from the processor 1510, or may be integrated into the processor 1510.

Optionally, the chip 1500 may further include an input interface 1530. Herein, the processor 1510 may control the input interface 1530 to communicate with other devices or chips, and specifically, to acquire information or data sent from other devices or chips.

Optionally, the chip 1500 may further include an output interface 1540. Herein, the processor 1510 may control the output interface 1540 to communicate with other devices or chips, and specifically, to output information or data to other devices or chips.

Optionally, the chip may be applied to the network device in the embodiments of the present application, and the chip may implement corresponding procedures implemented by the network device in respective methods in the embodiments of the present application, which will not be repeated herein for the sake of brevity.

Optionally, the chip may be applied to the user equipment in the embodiments of the present application, and the chip may implement corresponding procedures implemented by the user equipment in respective methods in the embodiments of the present application, which will not be repeated herein for the sake of brevity.

It should be understood that the chip mentioned in the embodiments of the present application may also be called a system-level chip, a system chip, a chip system or a system-on-chip chip, etc.

FIG. 16 is a schematic block diagram of a communication system 1600 provided in the embodiments of the present application. As shown in FIG. 16, the communication system 1600 includes a user equipment 1610 and a network device 1620.

The user equipment 1610 may be used to implement corresponding functions implemented by the user equipment in the methods described above, and the network device 1620 may be used to implement corresponding functions implemented by the network device in the methods described above, which will not be repeated herein for the sake of brevity.

It should be understood that the processor in the embodiments of the present application may be an integrated circuit chip with signal processing capabilities. In the implementation process, respective steps of the above method embodiments can be completed by an integrated logic circuit of hardware in a processor or an instruction in software form. The above-mentioned processor may be a general-purpose processor, a Digital Signal Processor (DSP), an Application Specific Integrated Circuit (ASIC), a Field Programmable Gate Array (FPGA) or other programmable logic devices, a discrete gate or a transistor logic device, or a discrete hardware component. Various methods, steps and logical block diagrams disclosed in the embodiments of the present application may be implemented or performed. A general-purpose processor may be a microprocessor, or the processor may also be any conventional processor, etc. The steps of the method disclosed in combination with the embodiments of the present application may be directly embodied as being performed and completed by a hardware decoding processor, or by using a combination of hardware and software modules in the decoding processor. The software module may be located in the mature storage medium in the art such as the random memory, the flash memory, the read-only memory, the programmable read-only memory or erasable programmable memory, the register. The storage medium is located in the memory, and the processor reads the information in the memory and completes the steps of the above methods in combination with its hardware.

It may be understood that, the memory in the embodiments of the present application may be a volatile memory or a non-volatile memory, or may include both volatile and non-volatile memories. Herein, the non-volatile memory may be a Read-Only Memory (ROM), a programmable read-only memory (Programmable ROM, PROM), an erasable programmable read-only memory (Erasable PROM, EPROM), an electrically erasable programmable read-only memory (Electrically EPROM, EEPROM) or a flash memory. The volatile memory may be a Random Access Memory (RAM), which is used as an external cache. Through illustrative, rather than limiting, illustration, many forms of RAMs are available, for example, a static random access memory (Static RAM, SRAM), a dynamic random access memory (Dynamic RAM, DRAM), a synchronous dynamic random access memory (Synchronous DRAM, SDRAM), a double data rate synchronous dynamic random access memory (Double Data Rate SDRAM, DDR SDRAM), an enhanced synchronous dynamic random access memory (Enhanced SDRAM, ESDRAM), a synchronous link dynamic random access memory (Synchlink DRAM, SLDRAM) and a direct Rambus random access memory (Direct Rambus RAM, DR RAM). It should be noted that, the memory of the system and the method described herein is intended to include, but not limited to, these and any other suitable types of memories.

It should be understood that, the above memory is exemplary but not the limited illustration, e.g., the memory in embodiments of the present application may also be a static Random Access Memory (static RAM, SRAM), a dynamic Random Access Memory (dynamic RAM, DRAM), a synchronous dynamic Random Access Memory (synchronous DRAM, SDRAM), a double data rate synchronous dynamic Random Access Memory (double data rate SDRAM, DDR SDRAM), an enhanced synchronous dynamic Random Access Memory (enhanced SDRAM, ESDRAM), a synch link dynamic Random Access Memory (synch link DRAM, SLDRAM), and a Direct Rambus Random Access Memory (Direct Rambus RAM, DR RAM), etc. That is, the memory in the embodiments of the present application is intended to include, but not limited to, these and any other suitable types of memories.

The embodiments of the present application further provide a computer-readable storage medium for storing a computer program.

Optionally, the computer-readable storage medium may be applied to the network device in the embodiments of the present application, and the computer program causes a computer to execute the corresponding processes implemented by the network device in respective methods in the embodiments of the present application, which will not be repeated herein for the sake of brevity.

Optionally, the computer-readable storage medium may be applied to the user equipment in the embodiments of the present application, and the computer program causes a computer to execute the corresponding processes implemented by the user equipment in respective methods in the embodiments of the present application, which will not be repeated herein for the sake of brevity.

The embodiments of the present application further provide a computer program product, which includes a computer program instruction.

Optionally, the computer program product may be applied to the network device in the embodiments of the present application, and the computer program instruction causes a computer to execute the corresponding processes implemented by the network device in respective methods in the embodiments of the present application, which will not be repeated herein for the sake of brevity.

Optionally, the computer program product may be applied to the user equipment in the embodiments of the present application, and the computer program instruction causes a computer to execute the corresponding processes implemented by the user equipment in respective methods in the embodiments of the present application, which will not be repeated herein for the sake of brevity.

The embodiments of the present application further provide a computer program.

Optionally, the computer program may be applied to the network device in the embodiments of the present application. When the computer program is executed on a computer, the computer is caused to execute the corresponding processes implemented by the network device in respective methods in the embodiments of the present application, which will not be repeated herein for the sake of brevity.

Optionally, the computer program may be applied to the user equipment in the embodiments of the present application. When the computer program is executed on a computer, the computer is caused to execute the corresponding processes implemented by the user equipment in respective methods in the embodiments of the present application, which will not be repeated herein for the sake of brevity.

Those ordinary skilled in the art may realize that, units and algorithm steps of the examples described in combination with the embodiments disclosed herein can be implemented in electronic hardware or in a combination of computer software and electronic hardware. Whether these functions are performed by way of hardware or software depends on a specific application and a design constraint of the technical solution. A skilled person may use different methods for each specific application, to implement the described functions, but such implementation should not be considered beyond the scope of the embodiments of the present application.

It may be clearly understood by those skilled in the art that, for convenience and brevity of the description, specific working procedures of the system, the apparatus and the unit described above may refer to the corresponding procedures in the above method embodiments, which will not be repeated here.

In the several embodiments provided by the application, it should be understood that, the disclosed systems, apparatus, and method may be implemented in other ways. For example, the apparatus embodiments described above are only schematic, for example, the division of the units is only the division of logical functions, and there may be other division methods in an actual implementation, for example, a plurality of units or components may be combined or integrated into another system, or some features may be ignored or not be performed. On the other hand, the coupling or direct coupling or communicative connection with each other as shown or discussed may be indirect coupling or communicative connection of apparatus or units via some interfaces, which may be electrical, mechanical, or in other forms.

The units illustrated as separate components may be or may not be physically separated, and the components shown as units may be or may not be physical units, that is, they may be located in one place, or may also be distributed among a plurality of network units. A part or all of the units may be selected according to actual needs, to implement the purpose of the solutions of the embodiments.

In addition, various functional units in the various embodiments of the present application may be integrated into one processing unit, or the various units may physically exist separately, or two or more units may be integrated into one unit.

If the described functions are implemented in a form of a software functional unit and sold or used as an independent product, they may be stored in a computer readable storage medium. Based on this understanding, the technical solution of the embodiments of the present application essentially, or a part of the technical solution that contributes to the prior art, or a part of the technical solution, may be embodied in a form of a software product, and the computer software product is stored in a storage medium, and includes a plurality of instructions for enabling a computer device (which may be a personal computer, a server, or a network device, etc.) to perform all or some of steps of the methods described in the various embodiments of the present application. And, the storage medium mentioned above includes various mediums that may store program codes, such as a USB flash drive (U disk), a mobile hard disk, a read-only memory (ROM), a random access memory (RAM), a diskette, or an optical disk, etc.

The above is only a specific implementation of the present application, but the protection scope of the present application is not limited thereto, and any skilled familiar with this technical field may easily think of changes or substitutions within the technical scope disclosed in the present application, which should be all covered within the protection scope of the present application. Therefore, the protection scope of the present application should be subject to the protection scope of claims.

## Claims

1. A beam management method, the method comprising:
measuring, by a user equipment (UE), link qualities of multiple beams or multiple beam pairs; and
determining, by the UE, at least one receiving beam index and/or uplink feedback information by utilizing a first sub-model based on the link qualities of the multiple beams or the multiple beam pairs, wherein the uplink feedback information is used to determine at least one transmitting beam index and/or at least one link quality corresponding to the at least one transmitting beam index.

2. The method according to claim 1, wherein in a case where the UE determines the uplink feedback information, the method further comprises:
sending, by the UE, the uplink feedback information to a network device, wherein the uplink feedback information is used for the network device to determine the at least one transmitting beam index and/or the at least one link quality corresponding to the at least one transmitting beam index by utilizing a second sub-model.

3. The method according to claim 1 or 2, wherein the multiple beams are multiple receiving beams or multiple transmitting beams, and the multiple beam pairs are multiple pairs of transmitting beam and receiving beam.

4. The method according to claim 3, wherein the at least one receiving beam index comprises indexes of K receiving beams with a best link quality in the multiple beams or the multiple beam pairs, and K is a positive integer.

5. The method according to claim 3, wherein the at least one transmitting beam index comprises indexes of K transmitting beams with a best link quality in the multiple beams or the multiple beam pairs, and K is a positive integer.

6. The method according to any one of claims 1 to 5, wherein there is a correspondence relationship between any two of the at least one receiving beam index, the at least one transmitting beam index, and the at least one link quality.

7. The method according to claim 6, wherein the correspondence relationship is determined by a sort of the at least one receiving beam index, a sort of the at least one transmitting beam index, and a sort of the at least one link quality.

8. The method according to any one of claims 1 to 7, wherein the first sub-model comprises an output layer;
determining, by the UE, the at least one receiving beam index and/or the uplink feedback information by utilizing the first sub-model based on the link qualities of the multiple beams or the multiple beam pairs, comprises:
performing processing, by the UE, on the link qualities of the multiple beams or the multiple beam pairs by utilizing the first sub-model to output at least one receiving beam index through a first part of nodes of the output layer, and output first information through a second part of the nodes of the output layer, wherein the first information is used to determine the uplink feedback information.

9. The method according to any one of claims 1 to 7, wherein the first sub-model comprises a first output layer and a second output layer;
determining, by the UE, the at least one receiving beam index and/or the uplink feedback information by utilizing the first sub-model based on the link qualities of the multiple beams or the multiple beam pairs, comprises:
performing processing, by the UE, on the link qualities of the multiple beams or the multiple beam pairs by utilizing the first sub-model to output at least one receiving beam index through the first output layer, and output first information through the second output layer, wherein the first information is used to determine the uplink feedback information.

10. The method according to claim 9, wherein in the first sub-model, the first output layer is adjacent to the second output layer, or the first output layer is separated from the second output layer by at least one neural network layer.

11. The method according to claim 9 or 10, wherein in the first sub-model, the first output layer is located in front of the second output layer, or the first output layer is located behind the second output layer.

12. The method according to any one of claims 9 to 11, wherein in a case where the first output layer is located in front of the second output layer.
the second output layer is a last neural network layer of the first sub-model; and
the first output layer is a middle neural network layer of the first sub-model.

13. The method according to any one of claims 9 to 11, wherein in a case where the first output layer is located behind the second output layer,
the first output layer is a last neural network layer of the first sub-model; and the second output layer is a middle neural network layer of the first sub-model.

14. The method according to any one of claims 9 to 11, wherein in a case where the first output layer is located behind the second output layer,
the first output layer is a last neural network layer of the first sub-model; and
the second output layer is a first neural network layer of the first sub-model.

15. The method according to claim 14, wherein an input of the first neural network layer comprises link qualities of the multiple beams or the multiple beam pairs.

16. The method according to any one of claims 9 to 15, wherein there is an association between the first output layer and the second output layer, or there is no association between the first output layer and the second output layer.

17. The method according to any one of claims 8 to 16, wherein the first sub-model further comprises a quantization layer, and the method further comprises:
performing, by the UE, quantization processing on the first information through the quantization layer to obtain the uplink feedback information.

18. The method according to claim 17, wherein the uplink feedback information is a first bit sequence, and the first bit sequence is used to determine the at least one transmitting beam index and the at least one link quality corresponding to the at least one transmitting beam index.

19. The method according to claim 17, wherein the uplink feedback information is a second bit sequence, the second bit sequence is used to indicate the link qualities of the multiple beams or the multiple beam pairs, and the link qualities of the multiple beams or the multiple beam pairs are used to determine the at least one transmitting beam index and the at least one link quality corresponding to the at least one transmitting beam index.

20. The method according to any one of claims 1 to 19, wherein the method further comprises:
in a case where the at least one receiving beam index is one receiving beam index, receiving, by the UE, downlink transmission by adopting a receiving beam indicated by the one receiving beam index.

21. The method according to any one of claims 1 to 19, wherein the method further comprises:
in a case where the at least one receiving beam index comprises multiple receiving beam indexes, determining, by the UE, a first receiving beam index from the multiple receiving beam indexes, to receive downlink transmission by adopting a receiving beam indicated by the first receiving beam index.

22. The method according to claim 21, wherein determining, by the UE, the first receiving beam index from the multiple receiving beam indexes, comprises:
receiving, by the UE, first indication information sent from a network device, wherein the first indication information is used to indicate a first transmitting beam index adopted by the network device; and
determining, by the UE, the first receiving beam index corresponding to the first transmitting beam index based on a correspondence relationship between the at least one receiving beam index and the at least one transmitting beam index.

23. The method according to claim 22, wherein the first indication information is carried in a media access control-control element (MAC CE) or downlink control information (DCI).

24. The method according to any one of claims 1 to 23, wherein before determining, by the UE, the at least one receiving beam index and/or the uplink feedback information by utilizing the first sub-model based on the link qualities of the multiple beams or the multiple beam pairs, the method further comprises:
reporting, by the UE, a data set to a network device, wherein the data set is used for the network device to train the first sub-model; and
receiving, by the UE, a trained first sub-model sent from the network device.

25. The method according to claim 24, wherein the data set is further used for the network device to train a second sub-model, and the second sub-model is used for the network device to determine the at least one transmitting beam index and/or the at least one link quality corresponding to the at least one transmitting beam index based on the uplink feedback information.

26. The method according to claim 25, wherein
the first sub-model and the second sub-model are trained jointly; or,
the first sub-model and the second sub-model are trained independently.

27. The method according to any one of claims 24 to 26, wherein the data set comprises:
input data of the first sub-model, wherein the input data comprises link qualities of at least portion of beams or beam pairs in a first set of beams or beam pairs;
a label of output data of the first sub-model, wherein the label comprises indexes of K receiving beams with a best link quality in the first set of beams or beam pairs; and
a label of output data of a second sub-model, wherein the label comprises indexes of K transmitting beams with a best link quality in the first set of beams or beam pair set and corresponding K link qualities, and K is a positive integer.

28. The method according to any one of claims 1 to 27, wherein a link quality comprises at least one of: a layer 1-reference signal received power (L1-RSRP), a layer 1-signal to interference plus noise ratio (L1-SINR), or a layer 1-reference signal received quality (L1-RSRQ).

29. A beam management method, the method comprising:
receiving, by a network device, uplink feedback information sent from a UE; and
determining, by the network device, at least one transmitting beam index and/or at least one link quality corresponding to the at least one transmitting beam index by utilizing a second sub-model based on the uplink feedback information.

30. The method according to claim 29, wherein the uplink feedback information is a first bit sequence, and the first bit sequence is used to determine the at least one transmitting beam index and the at least one link quality corresponding to the at least one transmitting beam index.

31. The method according to claim 29, wherein the uplink feedback information is a second bit sequence, the second bit sequence is used to indicate link qualities of multiple beams or multiple beam pairs, and the link qualities of the multiple beams or the multiple beam pairs are used to determine the at least one transmitting beam index and the at least one link quality corresponding to the at least one transmitting beam index.

32. The method according to any one of claims 29 to 31, wherein the method further comprises:
in a case where the at least one transmitting beam index is one transmitting beam index, sending, by the network device, for downlink transmission by adopting a transmitting beam indicated by the one transmitting beam index.

33. The method according to any one of claims 29 to 31, wherein the method further comprises:
in a case where the at least one transmitting beam index is multiple transmitting beam indexes, selecting, by the network device, a first transmitting beam index from the multiple transmitting beam indexes to send downlink transmission by adopting a transmitting beam indicated by the first transmitting beam index.

34. The method according to claim 33, wherein the method further comprises:
sending, by the network device, first indication information to the UE, wherein the first indication information is used to indicate a first transmitting beam index adopted by the network device.

35. The method according to claim 34, wherein the first indication information is carried in an MAC CE or DCI.

36. The method according to claim 34, wherein before receiving, by the network device, the uplink feedback information sent from the UE, the method further comprises:
receiving, by the network device, a data set reported from the UE; and
training, by the network device, the second sub-model by utilizing the data set.

37. The method according to claim 36, wherein the data set is further used for the network device to train a first sub-model, and the first sub-model is used for the UE to determine at least one receiving beam index and/or uplink feedback information based on link qualities of multiple beams or multiple beam pairs.

38. The method according to claim 37, wherein the at least one receiving beam index comprises indexes of K receiving beams with a best link quality in the multiple beams or the multiple beam pairs, and K is a positive integer.

39. The method according to claim 37, wherein the at least one transmitting beam index comprises indexes of K transmitting beams with a best link quality in the multiple beams or the multiple beam pairs, and K is a positive integer.

40. The method according to any one of claims 37 to 39, wherein there is a correspondence relationship between any two of the at least one receiving beam index, the at least one transmitting beam index, and the at least one link quality.

41. The method according to claim 40, wherein the correspondence relationship is determined by a sort of the at least one receiving beam index, a sort of the at least one transmitting beam index, and a sort of the at least one link quality.

42. The method according to any one of claims 37 to 41, wherein
the first sub-model and the second sub-model are jointly trained; or,
the first sub-model and the second sub-model are trained independently.

43. The method according to any one of claims 37 to 42, wherein the method further comprises:
issuing, by the network device, a trained first sub-model to the UE.

44. The method according to any one of claims 36 to 43, wherein the data set comprises:
input data of a first sub-model, wherein the input data comprises link qualities of at least portion of beams or beam pairs in a first set of beams or beam pairs;
a label of output data of the first sub-model, wherein the label comprises indexes of K receiving beams with a best link quality in the first set of beam or beam pair; and
a label of output data of the second sub-model, wherein the label comprises indexes of K transmitting beams with a best link quality in the first set of beam or beam pair and corresponding K link qualities, and K is a positive integer.

45. The method according to any one of claims 29 to 44, wherein the link quality comprises at least one of: a L1-RSRP, a L1-SINR, a L1-RSRQ.

46. A beam management apparatus, applied to a UE, the apparatus comprising:
a measurement unit, configured to measure link qualities of multiple beams or multiple beam pairs; and
a processing unit, configured to determine at least one receiving beam index and/or uplink feedback information by utilizing a first sub-model based on the link qualities of the multiple beams or the multiple beam pairs; wherein the uplink feedback information is used to determine at least one transmitting beam index and/or at least one link quality corresponding to the at least one transmitting beam index.

47. A beam management apparatus, applied to a network device, the apparatus comprising:
a receiving unit, configured to receive uplink feedback information sent from a UE; and
a processing unit, configured to determine at least one transmitting beam index and/or at least one link quality corresponding to the at least one transmitting beam index by utilizing a second sub-model based on the uplink feedback information.

48. A user equipment, comprising: a processor and a memory, wherein the memory is configured to store a computer program, and the processor is configured to invoke and execute the computer program stored in the memory to perform the method according to any one of claims 1 to 28.

49. A network device, comprising: a processor and a memory, wherein the memory is configured to store a computer program, and the processor is configured to invoke and execute the computer program stored in the memory to perform the method according to any one of claims 29 to 45.

50. A chip, comprising: a processor, configured to invoke and execute a computer program from a memory, causing a device equipped with the chip to perform the method according to any one of claims 1 to 28.

51. A chip, comprising: a processor, configured to invoke and execute a computer program from a memory, causing a device equipped with the chip to perform the method according to any one of claims 29 to 45.

52. A computer-readable storage medium for storing a computer program, wherein the computer program causes a computer to perform the method according to any one of claims 1 to 28.

53. A computer-readable storage medium for storing a computer program, wherein the computer program causes a computer to perform the method according to any one of claims 29 to 45.

54. A computer program product comprising a computer program instruction, wherein the computer program instruction causes a computer to perform the method of any one of claims 1 to 28.

55. A computer program product comprising a computer program instruction, wherein the computer program instruction causes a computer to perform the method of any one of claims 29 to 45.

56. A computer program, wherein the computer program causes a computer to perform the method according to any one of claims 1 to 28.

57. A computer program, wherein the computer program causes a computer to perform the method according to any one of claims 29 to 45.
